# FASCICULE DE BREVET EUROPEEN

(11) **EP 3 261 117 B1**
(45) Date de publication et mention de la délivrance du brevet: **18.11.2020**
(21) Numéro de dépôt: 17176723.9
(22) Date de dépôt: 19.06.2017
(51) Int. Cl.: H01L 23/057, H01L 21/52, H01L 23/10

(54) **BOITIER DE DISPOSITIF MICROÉLECTRONIQUE**
GEHÄUSE FÜR MIKROELEKTRONISCHE VORRICHTUNG
MICROELECTRONIC DEVICE HOUSING

(30) Priorité: 22.06.2016 FR 1655795
(43) Date de publication de la demande: 27.12.2017
(73) Titulaire: Commissariat à l'Energie Atomique et aux Energies Alternatives, 75015 Paris (FR)
(72) Inventeur: SOURIAU, Jean-Charles, 38120 Saint-Égrève (FR)
(74) Mandataire: Decobert, Jean-Pascal

(56) Documents cités:
- EP-A1- 2 259 018
- EP-A2- 1 433 742
- US-A- 5 095 359
- US-A- 6 029 730

## Description

### DOMAINE DE L'INVENTION

La présente invention concerne en général les dispositifs microélectroniques. Elle s'adresse en particulier au packaging et à la connexion électrique de dispositifs microélectroniques intégrés dans des packagings. Le packaging correspond typiquement à des techniques d'assemblage et d'encapsulation des tels dispositifs.

Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

### ARRIERE-PLAN TECHNOLOGIQUE

L'emploi de dispositifs microélectroniques s'est amplifié et diversifié. On rencontre dorénavant de tels dispositifs dans des secteurs aussi variés que les appareils médicaux et les capteurs. Notamment, le développement des MEMS a généralisé les débouchés de la microélectronique. Il reste qu'au moins certaines applications méritent un packaging efficace de ces dispositifs.

Il existe des méthodes pour connecter électriquement des composants microélectroniques entre eux ou à un autre élément. La technique la plus courante consiste à utiliser un substrat d'interconnexion sur lequel sont reportés et connectés les composants. Les câbles peuvent être eux aussi soudés ou collés directement sur le substrat d'interconnexion. Afin d'assurer une protection, l'ensemble est généralement enrobé dans un polymère ou mis dans un boîtier.

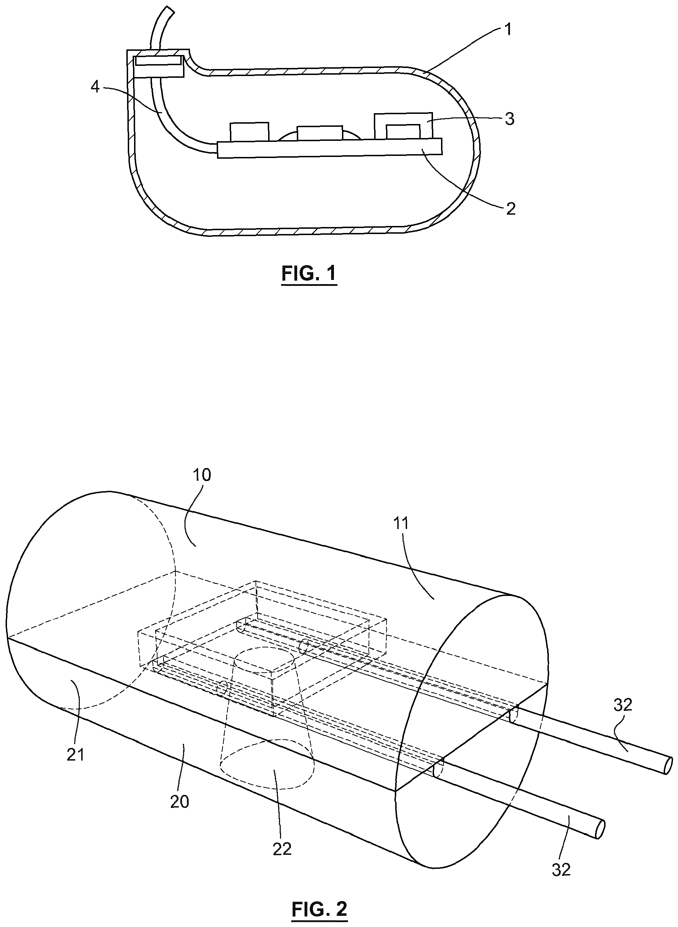

Par exemple, la publication WO2010/107926 A1 décrit un système électronique dans un boitier implantable dans le corps humain. La figure 1 de la présente demande reprend une figure du boîtier suivant cette publication. Ce système est doté de composants 3 portés par une puce 2 elle-même renfermée dans une coque 1 hermétique. La coque 1 peut être en plusieurs parties assemblées par soudage au niveau de leurs bordures. Une connexion par câbles 4 s'opère entre la puce 2 et l'extérieur, via des connecteurs en sortie de coque. Ce type de packaging est volumineux et la connexion électrique reste lourde et fastidieuse.

La publication brevet EP 2259018 A1 présente un élément de type MEMS qui comprend une cavité entre deux substrats et un élément de scellement formé en périphérie de ces derniers. Des éléments de raccordement électrique, sous forme d'éléments de contact susceptible d'être écrasé, sont présentés.

La publication brevet EP 1433742 A2 montre quant à elle l'encapsulation d'un dispositif portant un élément de type MEMS avec un montage du type «flip chip » d'une puce à l'intérieur d'une cavité formée entre deux substrats.

C'est donc un objet de l'invention que de pallier au moins en partie les inconvénients des techniques actuelles, en offrant un boitier amélioré.

### RESUME DE L'INVENTION

Un aspect de l'invention est relatif à un boitier pour dispositif microélectronique, comprenant une première partie et une deuxième partie assemblables pour définir, dans une position assemblée, un espace de logement du dispositif microélectronique, selon la revendication 1.

De manière avantageuse, une face de la première partie est en regard d'une face de la deuxième partie en position assemblée, des premières zones en regard des faces formant une interface de solidarisation desdites première partie et deuxième partie, des deuxièmes zones en regard des faces formant une cavité de réception du dispositif microélectronique. En outre, au moins l'une parmi la première partie et la deuxième partie comprend au moins un élément de raccordement électrique, la première partie et la deuxième partie étant configurées pour appliquer au moins un plot de connexion du dispositif microélectronique sur l'élément de raccordement en position assemblée. L'élément de raccordement électrique est débouchant dans la cavité.

Ainsi, on réalise un boitier qui embarque efficacement le dispositif microélectronique et en assure au moins partiellement la connexion électrique. De préférence, une pression produite par les deux parties du boitier en position assemblée fiabilise la liaison électrique et peut aussi permettre d'immobiliser le dispositif. Dans un mode de réalisation, le dispositif est plaqué entre le fond de la cavité et la face de la partie opposée du boitier, si bien que peu d'espace est perdu suivant cette direction, ce qui peut permettre une plus grande compacité du boitier si besoin. Au moins un élément de raccordement électrique débouchant dans la cavité comporte une tranchée configurée pour recevoir un câble de connexion.

Un autre aspect séparable de la présente invention concerne un système comprenant au moins un dispositif microélectronique et un boitier.

Un autre aspect de modes de réalisation de l'invention est relatif à un procédé de montage d'un dispositif microélectronique dans un boitier, le boitier comprenant une première partie et une deuxième partie assemblables pour définir, dans une position assemblée, un espace de logement du dispositif microélectronique, au moins l'une parmi la première partie et la deuxième partie comprenant au moins un élément de raccordement électrique, le procédé comprenant :
- une mise en place du dispositif microélectronique dans l'espace de logement, la première partie et la deuxième partie n'étant pas en position assemblée ;
- une mise en regard d'une face de la première partie et d'une face de la deuxième partie de sorte à placer lesdites parties en position assemblée, des premières zones en regard des faces formant une interface de solidarisation desdites première partie et deuxième partie, des deuxièmes zones en regard des faces formant une cavité de réception du dispositif microélectronique, l'élément de raccordement débouchant de préférence dans la cavité ;
- une application d'au moins un plot de connexion du dispositif microélectronique sur l'élément de raccordement en position assemblée de la première partie et de la deuxième partie,
ledit procédé étant selon la revendication 16.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- La FIGURE 1 illustre un exemple de boitier suivant la publication WO2010/107926.
- La FIGURE 2 montre en perspective un mode de réalisation de l'invention.
- Les FIGURES 3 et 4 montrent deux parties d'un boitier de l'invention dans deux états, respectivement dissociées et assemblées.
- Les FIGURES 4a, 4b et 4c présentent trois réalisations alternatives de connexion d'un dispositif microélectronique embarqué dans le boitier.
- Les FIGURES 5a, 5b et 5c illustrent trois modes d'assemblage différents pour deux parties d'un boitier.
- les FIGURES 6a et 6b révèlent une liaison charnière entre deux parties de boitier, respectivement en position ouverte et en position fermée.
- la FIGURE 7 montre une possibilité additionnelle de l'invention avec un organe compressible.
- la FIGURE 8 montre une possibilité additionnelle de l'invention avec une connexion supplémentaire pour le dispositif microélectronique.
- la FIGURE 9 est une vue en coupe longitudinale globale d'un boitier renfermant une pluralité de dispositifs microélectroniques et contient aussi des vues en coupe transversale à différents endroits le long du boitier.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- la première partie (10) est configurée pour exercer un appui sur le dispositif microélectronique (30) en direction de la face de la deuxième partie (20) ;
- la cavité (12) est délimitée par un motif en creux dans la première partie (10), le motif en creux présentant un fond (14) configuré pour exercer l'appui sur le dispositif microélectronique (30).
- au moins un élément de raccordement comporte une tranchée (24) configuré pour recevoir un câble de connexion et un organe d'interconnexion (34) débouchant dans la cavité (12) de manière à rendre applicable un plot de connexion (31) du dispositif microélectronique (30) sur l'organe d'interconnexion (34) en position assemblée, l'organe d'interconnexion (34) pouvant être relié électriquement au câble de connexion ;
- celle parmi la première partie (10) et la deuxième partie (20) qui ne comprend pas ledit élément de raccordement comprend un ergot (16) en regard de la tranchée(24) de l'élément de raccordement, configuré pour exercer un appui sur le câble (32) de connexion en position assemblée ;
- au moins un élément de raccordement comporte une tranchée (24, 17) débouchant de préférence dans la cavité (12) et configurée pour recevoir un câble (32) de connexion de manière à rendre applicable un plot de connexion (31) du dispositif microélectronique (30) sur le câble de connexion (32) en position assemblée ;
- la première partie (10) et la deuxième partie (20) comportent chacune au moins un élément de raccordement ;
- la cavité (12) comprend un organe compressible (35) configuré pour être comprimé par le dispositif microélectronique (30) dans la position assemblée ;
- au moins l'une parmi la première partie (10) et la deuxième partie (20) comporte une fenêtre débouchant dans la cavité (12) depuis la paroi externe de ladite partie ;
- le boîtier comprend des moyens de fixation mécanique et/ou par collage de la première partie (10) sur la deuxième partie (20) en position assemblée ;
- la première partie (10) et la deuxième partie (20) sont reliées par une liaison charnière (28) au niveau d'un bord de leurs faces.
- le système comprend plusieurs dispositifs microélectroniques dont au moins une partie est reliée électriquement par au moins un élément de raccordement.

Eventuellement, les options suivantes sont aussi possibles :
- les passages de câble sont parallèles et éventuellement dirigés suivant une direction longitudinale du boitier ;
- les moyens de fixation mécanique comprennent un organe de fixation sur une des parties apte à coopérer avec un logement dans l'autre des parties ;
- les moyens de fixation comprennent un organe de fixation avec une butée sur l'une des parties et une butée complémentaire sur l'autre partie, les butées étant configurées pour interdire le désassemblage des deux parties ;
- la fixation est réversible ; cela permet de changer le dispositif électronique si celui-ci est défectueux
- l'élément de raccordement comprend une couche d'interface entre le plot et l'élément de raccordement ; cette couche peut être une colle conductrice ou un matériau fusible conducteur ; cette couche peut être au contact d'un câble de connexion ;
- l'appui entre les deux parties du boitier est majoritairement voire totalement dirigé suivant une dimension en épaisseur du substrat du dispositif microélectronique ;
- le boitier comprend une pluralité de cavités chacune dédiée au logement d'un dispositif microélectronique.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément. Une couche peut par ailleurs être composée de plusieurs sous-couches d'un même matériau ou de matériaux différents.

Il est précisé que dans le cadre de la présente invention, l'épaisseur d'une couche ou d'un substrat se mesure selon une direction perpendiculaire à la surface selon laquelle cette couche ou ce substrat présente son extension maximale.

L'emploi du singulier pour certains éléments de l'invention ne signifie pas obligatoirement qu'un élément donné est présent de manière unique dans l'invention. Le mot « un » ou « une » ne signifie donc pas exclusivement respectivement « un seul » ou « une seule » à moins qu'il en soit disposé autrement.

L'invention ici proposée sert au packaging de dispositifs microélectroniques pouvant comporter plusieurs composants dont par exemple au moins un interagissant avec son environnement de préférence à travers une fenêtre. Les composants à connecter peuvent être un ASIC (c'est-à-dire circuit intégré à application spécifique), un capteur, un actuateur, un stimulateur, une batterie, une puce RFID (c'est-à-dire identification radiofréquence), des composants passifs.

Le composant interagissant avec son environnement peut être :
- un capteur de pression, un capteur optique, un capteur acoustique, un capteur électrique, un capteur thermique, un capteur biologique ;
- un stimulateur électrique, optique, acoustique, thermique ;
- une puce RFID ;
- une puce pour la délivrance de médicament ou le prélèvement de cellule biologique.

Dans le cas d'applications médicales, l'invention peut servir à embarquer, de manière efficace des composants aux fonctions notamment parmi les suivantes : capteur de pression sanguine in vivo, capteur de coagulation sanguine in vivo, capteur d'oxygène in vivo, stimulation photonique, stimulation acoustique, illumination proche infrarouge 650nm, 400n, 170nm, traitement des maladies dégénératives Alzheimer, traitement localisé des tumeurs , traitement optique de la périphérie des tumeurs, capteur du rythme cardiaque.

La figure 2 montre une vue générale en perspective d'un mode de réalisation de l'invention. Une première partie 10 et une deuxième partie 20 y sont assemblées de sorte à définir un espace présenté en traits pointillés permettant le logement d'un dispositif microélectronique qui peut être du type évoqué précédemment. Globalement, lorsque les parties 10 et 20 sont en position assemblée, elles définissent une paroi externe en deux portions respectivement 11 et 21. Si besoin, la surface extérieure ainsi formée peut être étanche à l'air et/ou à l'eau ou à tout autre fluide. La figure 2 représente par ailleurs des câbles 32 permettant la connexion électrique vers l'extérieur d'un ou plusieurs composants présents sur le dispositif microélectronique.

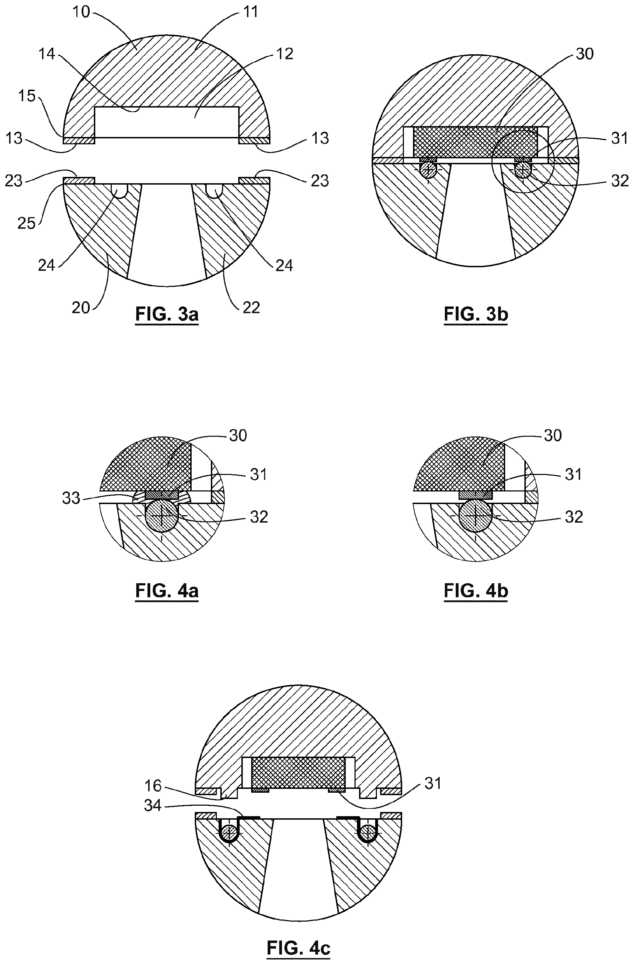

Une coupe transversale au niveau d'une cavité de réception du dispositif est présentée dans un premier mode de réalisation à la figure 3a. La première partie 10 comporte une paroi externe 11 qui est, dans l'exemple, en forme de demi-lune. À l'opposé de la paroi externe 11, une face de la première partie 10 est située en regard d'une face de la deuxième partie 20 entre la face et la paroi, la partie 10 peut être pleine ou creuse. Dans cet exemple, la deuxième partie 20 présente une configuration géométrique en coupe semblable à celle de la première partie 10. Les bords longitudinaux de la paroi externe 11 interceptent la face de la deuxième partie 20 en regard de celle de la première partie 10.

Le matériau utilisé pour l'une/ou l'autre des première et deuxième parties sera adaptée en fonction de l'application et notamment de la résistance, par exemple mécanique ou chimique, souhaitée. À titre d'exemple, on peut utiliser des matériaux polymères tels que les matières plastiques suivantes : Peek, Polyaryletherketone (PAEK), Polyester, thermoplastique, polychlorure de vinyle (PVC), polyéthylène, polycarbonate, polypropylène, polyuréthane, polysulfone, LCP (pour Liquid Crystal Polymer, c'est-à-dire polymère cristal liquide).

La fabrication du boîtier peut être réalisée notamment par l'un des procédés suivants : moulage par injection, moulage par compression, Impression 3D.

Une fois assemblées, les parties du boîtier peuvent réaliser une enveloppe présentant un diamètre allant de 1mm à 10mm et une longueur de 5 mm à 30 mm.

Toujours dans l'exemple de la figure 3a, la face de la première partie 10 comporte une première zone destinée à servir au contact avec une première zone correspondante de la deuxième partie 10. Par exemple, la première zone peut correspondre à une surface située en bordure de la face considérée ou encore à deux surfaces situées au niveau de deux bordures opposées de la face considérée. La première zone servant au contact avec l'autre partie forme avantageusement un contour fermé en périphérie de la face. Comme on le verra, des passages sous forme de tranchées 24 peuvent faire exception à ce contour fermé. Au niveau de la première zone de l'une et/ou l'autre des faces, une couche 15, 25 spécifique d'assemblage peut être réalisée, par exemple par un matériau favorisant l'étanchéité, par un matériau adhésif. On forme ainsi d'une manière générale des zones d'application réciproque des deux faces, correspondant aux repères 13 et 23 sur la figure 3a.

Outre les premières zones permettant la mise en contact de la première partie 10 et de la deuxième partie 20, les faces de ces parties 10, 20 comportent en outre une deuxième zone permettant de définir l'espace de logement du dispositif microélectronique. À cet effet, les faces délimitent une cavité 12 susceptible de recevoir ce dispositif 30 comme le montre la figure 3b. La cavité 12 peut comprendre un motif en creux réalisé dans la première partie 10 et présentant un fond 14 ainsi que des parois latérales. Dans l'exemple, la section de ce motif est rectangulaire. La zone en regard de la face de la deuxième partie 20 peut être sensiblement plane et constituer la couverture de la cavité 12 dont l'espace en creux est ainsi essentiellement formé par le motif en creux de la première partie 10. Cette configuration n'est bien entendue pas limitative et on pourrait notamment prévoir deux motifs en creux respectivement sur la première partie 10 et la deuxième partie 20, ces deux motifs coopérant de sorte à former l'ensemble de la hauteur de la cavité 12.

La cavité permet d'accueillir un dispositif microélectronique pouvant intégrer différentes fonctions. Elle est de préférence de forme parallélépipédique rectangle avec des dimensions typiques de la section de cavité: 3 à 30mm², pour une longueur de 2 mm à 25 mm.

De préférence, le fond 14 est configuré pour s'appliquer sur une surface du dispositif microélectronique 30. De préférence, cette application s'effectue plan sur plan. Par ailleurs, avantageusement, le fond 14 est une surface plane parallèle à la face supérieure du dispositif 30 sur laquelle il s'applique et/ou parallèle à la partie en regard de la face de la deuxième partie 20.

On peut préserver un jeu latéral entre le dispositif 30 et les parois latérales du motif en creux réalisant la cavité 12. Par contre, il n'y a avantageusement pas de jeu suivant la direction épaisse du dispositif entre ce dernier et le boîtier de sorte que le dispositif est immobilisé dans cette direction.

Avantageusement, la dimension en hauteur de la cavité 12, dirigée suivant l'épaisseur du substrat du dispositif microélectronique, est équivalente à l'épaisseur dudit dispositif. De cette façon, le dispositif est efficacement logé sans capacité de débattement à l'intérieur de la cavité 12. En outre, cela permet d'appliquer un effort en étau de part et d'autre du dispositif 30 par l'intermédiaire des parties 10, 20. En outre, la définition de la cavité 12 est l'opportunité de réaliser à ce niveau une connexion électrique d'un ou plusieurs composants montés sur ou dans le dispositif microélectronique vers l'extérieur ou vers un autre dispositif microélectronique du boîtier. Ainsi, des passages 24 peuvent être formés en débouchant dans la cavité 12. L'exemple fourni aux figures 3a et 3b présente deux tranchées 24 réalisées dans la deuxième partie 20. Dans l'illustration, les passages sont sous forme de tranchées 24 parallèles entre elles et qui peuvent par ailleurs être parallèles à un axe longitudinal du boîtier. Les tranchées permettent d'accueillir chacune un câble, de préférence un micro câble qui peut avoir un diamètre compris entre 25µm et 4 mm. Les câbles 32 logés dans les tranchées 24 permettent un raccordement électrique du dispositif microélectronique logé dans la cavité 12. Ce raccordement peut notamment servir à une alimentation électrique et/ou à la communication de données. On peut utiliser des câbles 32 compressibles.

Avantageusement, dans le mode de réalisation illustré à la figure 3b, les tranchées 24 débouchent au niveau de la cavité 12 et présentent une hauteur inférieure au diamètre des câbles 32 de sorte à produire un dépassement d'une portion du câble 32 vers l'intérieur de la cavité 12. Grâce à cette mise en saillie, une portion du câble 32 peut être mise au contact d'un plot 31 présent sur la face en regard du dispositif 30. On s'arrange bien entendu pour faire coïncider la localisation des tranchées 24 et des plots 31 à placer en continuité électrique. Il peut y avoir autant de passages 24 que de plots 31 à connecter. Mais, un seul câble 32 peut servir à connecter plusieurs plots 31.

Dans la présente demande, on entend par plot 31 tout organe porté par le dispositif microélectronique 30 susceptible de constituer une borne d'entrée et/ou de sortie électrique pour toute partie ou composant de ce dispositif 30. La forme des plots 31 illustrée n'est aucunement limitative de l'invention.

Dans un mode de réalisation, la distance entre le fond 14 de la cavité 12 et le sommet du câble 32 faisant saillie vers l'intérieur de la cavité 12 est inférieure ou égale, et de préférence inférieure de moins de 10 %, à la hauteur du dispositif 30 à ce même niveau (incluant donc la hauteur du plot 31). On garantit ainsi une application ferme du plot 31 contre le câble 32. Éventuellement, on peut jouer sur une certaine déformabilité de la section du câble 32 pour accommoder cette phase d'application. Ainsi, dans la vue de détail donnée à la figure 4b, la coopération entre le plot 31 et le câble 32 s'opère directement.

Dans le mode de réalisation fourni à la figure 4a, une couche d'interface 33 est ajoutée au niveau du contact entre le plot 31 et le câble 32. La couche d'interface 33 peut être constituée par une colle conductrice électriquement ou par un matériau fusible conducteur d'électricité. Outre une amélioration de la conduction électrique entre les deux parties, cette configuration permet une augmentation de la cohérence mécanique finale.

Dans un autre mode de réalisation, les tranchées 24 sont déportées relativement à la cavité 12 et ne débouchent pas dans celle-ci. C'est le cas de la figure 4c présentant des passages 24 décalés relativement à la zone en regard des faces des parties 10, 20 définissant la cavité 12. Pour permettre néanmoins une connexion vers l'extérieur des plots 31, des organes d'interconnexion 34 sont prévus en coopération chacun avec une tranchée 24. Les organes d'interconnexion 34 peuvent être fabriqués sous forme de zones métallisées couvrant au moins partiellement la tranchée 24 considérée et s'étendant vers l'intérieur de la cavité 12 de sorte à être localisé en regard du plot 31 concerné par la connexion. Ainsi, les passages peuvent être des tranchées 24 au moins partiellement métallisées et des pistes électriques qui permettent de déporter les contacts électriques en regard des plots 31. La métallisation peut être réalisée par des procédés tels que les suivants : procédé par activation laser (LDS), procédé par bi-injection (avec un matériau non métallisable et un matériau métallisable), procédé par jet d'encre conductrice.

Toujours en référence au mode de réalisation de la figure 4c, la partie située en regard de celle comportant la tranchée 24 considérée peut comporter un ergot 16 permettant d'exercer un appui sur le câble 32 logé dans la tranchée 24 pour s'assurer de la bonne application de ces derniers l'un contre l'autre. Le terme « ergot » est employé au sens large ; il peut s'agir d'une ou plusieurs protubérances ponctuelles le long de la tranchée 24 ou d'une marche continue le long du passage. Dans ce mode de réalisation, la hauteur du passage 24 est de préférence inférieure au diamètre du câble 32 de sorte à ménager un espace au-dessus du câble 32 pour la réception de la saillie constituée par l'ergot 16. De préférence, cet espace reste inférieur ou égal, et de préférence inférieur de moins de 10 %, à la hauteur de l'ergot 16 susceptible d'être introduit dans le passage de sorte à produire une application de l'ergot 16 contre le câble 32 et, en conséquence, la fiabilité de l'application du câble 32 sur l'organe d'interconnexion 34.

On a décrit précédemment des possibilités de réalisation d'un ou plusieurs éléments de raccordement permettant la connexion électrique du dispositif 30 avec un élément extérieur au boîtier ou avec un élément additionnel du boîtier.

On comprend que dans un premier mode de réalisation un élément de raccordement comprend une tranchée 24 apte à coopérer avec un câble 32. Dans un deuxième mode de réalisation, l'élément de raccordement comprend une tranchée 24, un organe d'interconnexion 34 et possiblement un câble 32. D'autres types d'éléments de raccordement peuvent rentrer dans le cadre de la présente invention.

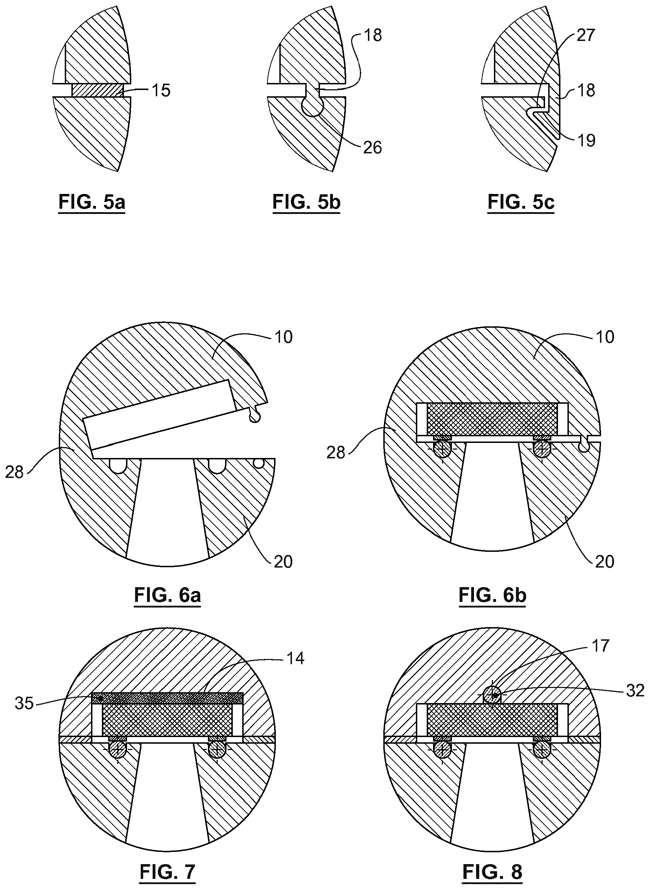

Une fois qu'un dispositif 30 a été logé de façon convenable dans la cavité 12, le boîtier de l'invention comporte des moyens assurant le maintien en position assemblée des parties 10, 20. Ces deux fixations peuvent être amovibles en ce sens qu'il est possible ultérieurement de rouvrir le boîtier de sorte à extraire le dispositif 30 et éventuellement à le remplacer. Dans un autre mode de réalisation, la fixation peut être définitive. Ainsi, dans le mode de réalisation présentée à la figure 5a, une couche de colle 15 est réalisée à l'interface entre les parties 10, 20, au niveau de la première zone des faces.

Par contre, l'exemple de la figure 5b montre une fixation mécanique par l'intermédiaire d'un organe de fixation 18, porté par exemple par la partie 10, et formant une partie mâle apte à s'insérer dans un logement 26, porté par l'autre partie, et formant une partie femelle dans laquelle la partie mâle s'encastre. L'organe de fixation 18 peut être un bouton. Plusieurs boutons peuvent être répartis sur le contour du boîtier. En outre, le terme bouton couvre également la réalisation d'un profil continu sur au moins une partie du contour des faces des parties 10, 20.

Une réalisation alternative est illustrée à la figure 5c dans laquelle l'organe de fixation 18 comporte une extrémité en crochet définissant une butée 19 apte à coopérer avec une forme correspondante sur l'autre partie du boîtier, disposant d'une butée 27 apte à s'opposer au retrait de la partie 18 en forme de crochet. Avantageusement, l'insertion de la butée 19 contre la butée 27 s'opère par déformation élastique de l'organe 18.

Les moyens de fixation, notamment ceux décrits précédemment, peuvent être répartis sur plusieurs bordures, notamment les bords longitudinaux opposés des faces des parties 10, 20. Cependant, les parties 10, 20 peuvent aussi être partiellement solidaires, même en position non assemblée. Un exemple en est donné aux figures 6a et 6b. La figure 6a montre une configuration ouverte du boîtier dans laquelle les parties 10, 20 sont solidaires par un de leurs bords longitudinaux qui est commun et qui réalise une zone charnière 28. On pourra jouer sur la déformabilité de cette zone pour passer de la position ouverte à la position fermée du boîtier. Cette déformabilité peut être fournie par une limitation de la section de la zone charnière 28 et/ou par la sélection d'un matériau dont le module de Young ne lui procure pas trop de rigidité. Cela est possible par exemple avec des matériaux plastiques dont le module d'Young est inférieur à 20GPa.

On notera que l'on peut jouer sur la déformation avantageusement élastique mais potentiellement également plastique du boîtier lorsqu'il est placé en position assemblée pour opérer une application efficace des parties 10, 20 de sorte à s'appliquer de part et d'autre du dispositif 30. Avantageusement, l'appui exercé sur le dispositif 30 est dirigé majoritairement ou totalement suivant l'épaisseur du dispositif 30 de sorte à produire un effort non nul à l'interface entre le plot 31 et un câble 32 ou un organe d'interconnexion 34.

La figure 6b montre le résultat du passage de la charnière 28 vers la position assemblée.

La figure 7 présente une autre possibilité de l'invention avec une couche compressible 35 disposée au niveau du fond 14 de la cavité 12 de sorte à produire un appui plus souple sur le dispositif 30 lors du passage en position assemblée. Avantageusement, le matériau compressible est déformable élastiquement ; il peut s'agir de silicone ou d'élastomère. Les dimensions des éléments sont configurées de sorte à déformer la couche 35 lorsque le dispositif 30 est en place dans la cavité 12 et lorsque les parties 10, 20 sont en position assemblée.

Une autre option est présentée à la figure 8 avec la présence d'un élément de raccordement additionnel au niveau de la première partie 10 et non seulement au niveau de la deuxième partie 20. Dans le cas d'espèce, un passage 17 reçoit un câble 32, le passage et le câble pouvant être du même type que ceux décrits précédemment. Par exemple, le passage 17 peut être situé au milieu de la largeur de la cavité 12.

Les différentes figures montrent par ailleurs la présence d'une fenêtre 22 passant au travers de l'une des parties, en l'espèce la partie 20. Cette fenêtre débouche dans la cavité 12 et communique avec l'extérieur, en traversant la paroi externe de la partie qui la comporte. De préférence, la fenêtre 22 est située de sorte à déboucher sur l'une des faces du dispositif 30 et de préférence sur la face opposée à celle appliquée sur le fond 14 de la cavité 12. Cette fenêtre peut servir à laisser passer un fluide, tel qu'un gaz ou un liquide, ou encore à assurer la transmission d'ondes électromagnétiques ou acoustiques. La fenêtre n'est pas forcément un trou béant et peut éventuellement être au moins partiellement rempli, par exemple avec un matériau transparent, notamment pour réaliser une lentille optique, par exemple pour opérer une focalisation. Avantageusement, l'axe longitudinal de la fenêtre au travers de la partie qui en est dotée est perpendiculaire au fond 14 de la cavité.

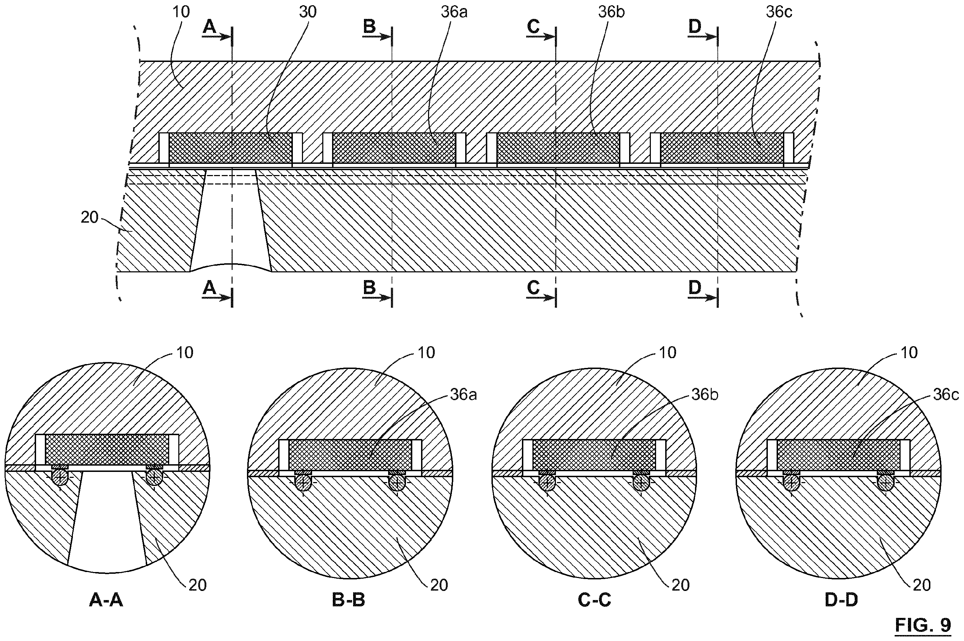

La figure 9 fournit une variante des différents exemples précédents dans la mesure où une pluralité de dispositifs sont embarqués dans un seul boîtier. Plus précisément, outre le dispositif 30, au moins un dispositif additionnel 36a,b,c est présent. Avantageusement, le boîtier comporte autant de cavités que de dispositifs à loger. De plus, ces dispositifs peuvent s'enchaîner suivant une direction longitudinale du boîtier. En outre, au moins un élément de raccordement peut être commun à au moins deux de ces dispositifs. Par exemple, au moins un passage s'étend à la fois au niveau du dispositif 30 et au niveau d'au moins des dispositifs additionnels 36a,b,c. On peut ainsi utiliser un seul câble 32 et un seul passage 24 ou 17 pour raccorder différents dispositifs entre eux et/ou à l'extérieur. Dans le cas illustré, le dispositif 30 peut être un capteur, le dispositif 36a peut-être une puce RFID, le dispositif 36b peut être une puce à fonction spécifique ASIC et le dispositif 36c une batterie électrique. Un tel ensemble peut être autonome.

On notera par cette disposition qu'il n'est pas absolument nécessaire de disposer d'un élément de raccordement allant vers l'extérieur du boîtier. Ainsi, les tranchées 24, 17 ne débouchent pas forcément vers l'extérieur des parties 10, 20 du boîtier. Il peut donc s'agir de tranchées ne débouchant pas latéralement.

Sauf indication spécifique du contraire, des caractéristiques techniques décrites en détail pour un mode de réalisation donné peuvent être combinées à des caractéristiques techniques décrites dans le contexte d'autres modes de réalisation décrits à titre exemplaire et non limitatif, dont ceux expliqués en détail ci-dessus.

### REFERENCES

- 1.: Coque
- 2.: Puce
- 3.: Composant
- 4.: Câble
- 10.: Première partie
- 11.: Paroi externe
- 12.: Cavité
- 13.: Zone d'application
- 14.: Fond
- 15.: Couche de colle
- 16.: Ergot
- 17.: Tranchée Organe de fixation
- 18.: Butée
- 20.: Deuxième partie
- 21.: Paroi externe
- 22.: Fenêtre
- 23.: Zone d'application
- 24.: Tranchée
- 25.: Couche de colle
- 26.: Logement
- 27.: Butée
- 28.: Zone charnière
- 30.: Dispositif microélectronique
- 31.: Plot
- 32.: Câble
- 33.: Couche d'interface
- 34.: Organe d'interconnexion
- 35.: Couche compressible
- 36 a,b,c: Dispositif microélectronique additionnel

## Revendications

1. Boitier pour dispositif microélectronique, comprenant une première partie (10) et une deuxième partie (20) assemblables pour définir, dans une position assemblée, un espace de logement du dispositif microélectronique (30), dans lequel une face de la première partie (10) est en regard d'une face de la deuxième partie (20) en position assemblée, des premières zones en regard des faces formant une interface de solidarisation desdites première partie (10) et deuxième partie (20), des deuxièmes zones en regard des faces formant une cavité (12) de réception du dispositif microélectronique (30), au moins l'une parmi la première partie (10) et la deuxième partie (20) comprenant au moins un élément de raccordement électrique comprenant un câble de connexion (32), débouchant dans la cavité (12) et comportant une tranchée (24) recevant le câble de connexion (32), la première partie (10) et la deuxième partie (20) étant configurées pour appliquer au moins un plot de connexion (31) du dispositif microélectronique (30) sur l'élément de raccordement, par une pression produite par la première partie (10) et la deuxième partie (20), en position assemblée.

2. Boitier selon la revendication précédente, dans lequel la première partie (10) est configurée pour exercer un appui sur le dispositif microélectronique (30) en direction de la face de la deuxième partie (20).

3. Boitier selon la revendication précédente, dans lequel la cavité (12) est délimitée par un motif en creux dans la première partie (10), le motif en creux présentant un fond (14) configuré pour exercer l'appui sur le dispositif microélectronique (30).

4. Boitier selon l'une des revendications précédentes, dans lequel au moins un élément de raccordement comporte un organe d'interconnexion (34) débouchant dans la cavité (12) de manière à rendre applicable un plot de connexion (31) du dispositif microélectronique (30) sur l'organe d'interconnexion (34) en position assemblée, l'organe d'interconnexion (34) étant relié électriquement au câble de connexion (32).

5. Boitier selon la revendication précédente, dans lequel celle parmi la première partie (10) et la deuxième partie (20) qui ne comprend pas ledit élément de raccordement comprend un ergot (16) en regard de la tranchée (24) de l'élément de raccordement, configuré pour exercer un appui sur le câble de connexion (32) en position assemblée.

6. Boitier selon l'une des revendications précédentes, dans lequel la tranchée (24, 17) d'au moins un élément de raccordement débouche dans la cavité (12) et reçoit le câble de connexion (32) de manière à permettre l'application d'un plot de connexion (31) du dispositif microélectronique (30) sur le câble de connexion (32) en position assemblée.

7. Boitier selon la revendication précédente, dans lequel le câble de compression (32) est compressible.

8. Boitier selon l'une des deux revendications précédentes, dans lequel la hauteur de la tranchée (24, 17) est inférieure au diamètre du câble de connexion (32).

9. Boitier selon l'une des revendications précédentes, dans lequel la première partie (10) et la deuxième partie (20) comportent chacune au moins un élément de raccordement.

10. Boitier selon l'une des revendications précédentes, dans lequel la cavité (12) comprend un organe compressible (35) déformable élastiquement et configuré pour être comprimé par le dispositif microélectronique (30) dans la position assemblée.

11. Boitier selon l'une des revendications précédentes, dans lequel au moins l'une parmi la première partie (10) et la deuxième partie (20) comporte une fenêtre débouchant dans la cavité (12) depuis la paroi externe de ladite partie.

12. Boitier selon l'une des revendications précédentes, comprenant des moyens de fixation mécanique et/ou par collage de la première partie (10) sur la deuxième partie (20) en position assemblée.

13. Boitier selon l'une des revendications précédentes, dans lequel la première partie (10) et la deuxième partie (20) sont reliées par une liaison charnière (28) au niveau d'un bord de leurs faces.

14. Système comprenant au moins un dispositif microélectronique (30) logé à l'intérieur de la cavité 12 d'un boitier selon l'une des revendications précédentes.

15. Système selon la revendication précédente, comprenant plusieurs dispositifs microélectroniques logés à l'intérieur de la cavité 12, au moins une partie desdits dispositifs microélectroniques étant reliée électriquement par au moins un élément de raccordement.

16. Procédé de montage d'un dispositif microélectronique dans un boitier, le boitier comprenant une première partie (10) et une deuxième partie (20) assemblables pour définir, dans une position assemblée, un espace de logement du dispositif microélectronique (30), au moins l'une parmi la première partie et la deuxième partie comprenant au moins un élément de raccordement électrique, le procédé comprenant :
- une mise en place du dispositif microélectronique (30) dans l'espace de logement, la première partie (10) et la deuxième partie (20) n'étant pas en position assemblée ;
- une mise en regard d'une face de la première partie (10) et d'une face de la deuxième partie (20) de sorte à placer lesdites parties en position assemblée, des premières zones en regard des faces formant une interface de solidarisation desdites première partie et deuxième partie, des deuxièmes zones en regard des faces formant une cavité (12) de réception du dispositif microélectronique (30), l'élément de raccordement débouchant dans la cavité (12) et comportant une tranchée (24) recevant un câble de connexion (32),
- une application d'au moins un plot de connexion (31) du dispositif microélectronique (30) sur l'élément de raccordement en position assemblée de la première partie (10) et de la deuxième partie (20), par une pression produite par la première partie (10) et la deuxième partie (20).

17. Utilisation d'au moins un boitier selon l'une des revendications 1 à 13 pour le logement d'un dispositif microélectronique dans la cavité du boitier.

## Patentansprüche

1. Gehäuse für eine mikroelektronische Vorrichtung, umfassend einen ersten Teil (10) und einen zweiten Teil (20), die zusammensetzbar sind, um in einer zusammengesetzten Position einen Raum zur Aufnahme der mikroelektronischen Vorrichtung (30) zu definieren, in dem sich eine Seite des ersten Teils (10) in zusammengesetzter Position gegenüber einer Seite des zweiten Teils (20) befindet, wobei erste Zonen gegenüber den Seiten eine Schnittstelle zur festen Verbindung des ersten Teils (10) und zweiten Teils (20) bilden, zweite Zonen gegenüber den Seiten einen Hohlraum (12) zur Aufnahme der mikroelektronischen Vorrichtung (30) bilden, wobei mindestens einer aus dem ersten Teil (10) und dem zweiten Teil (20) mindestens ein elektrisches Anschlusselement umfasst, das ein Verbindungskabel (32) umfasst, das in den Hohlraum (12) mündet und einen Graben (24) beinhaltet, der das Verbindungskabel (32) aufnimmt, wobei der erste Teil (10) und der zweite Teil (20) konfiguriert sind, um mindestens einen Verbindungsklotz (31) der mikroelektronischen Vorrichtung (30) durch einen Druck an dem Anschlusselement anzulegen, der in zusammengesetzter Position durch den ersten Teil (10) und den zweiten Teil (20) erzeugt wird.

2. Gehäuse nach dem vorstehenden Anspruch, wobei der erste Teil (10) konfiguriert ist, um eine Stützung auf die mikroelektronische Vorrichtung (30) in Richtung der Seite des zweiten Teils (20) auszuüben.

3. Gehäuse nach dem vorstehenden Anspruch, wobei der Hohlraum (12) durch ein Hohlmuster in dem ersten Teil (10) begrenzt wird, wobei das Hohlmuster einen Boden (14) aufweist, der konfiguriert ist, um die Stützung auf die mikroelektronische Vorrichtung (30) auszuüben.

4. Gehäuse nach einem der vorstehenden Ansprüche, wobei mindestens ein Anschlusselement ein Zwischenverbindungsorgan (34) beinhaltet, das in den Hohlraum (12) mündet, um den Verbindungsklotz (31) der mikroelektronischen Vorrichtung (30) an dem Zwischenverbindungsorgan (34) in zusammengesetzter Position anlegbar zu machen, wobei das Zwischenverbindungsorgan (34) elektrisch an das Verbindungskabel (32) gekoppelt ist.

5. Gehäuse nach dem vorstehenden Anspruch, wobei jener aus dem ersten Teil (10) und dem zweiten Teil (20), der das Anschlusselement nicht umfasst, eine Nase (16) gegenüber dem Graben (24) des Anschlusselements umfasst, die konfiguriert ist, um in zusammengesetzter Position eine Stützung auf das Verbindungskabel (32) auszuüben.

6. Gehäuse nach einem der vorstehenden Ansprüche, wobei der Graben (24, 17) mindestens eines Anschlusselements in den Hohlraum (12) mündet und das Verbindungskabel (32) derart empfängt, um das Anlegen eines Verbindungsklotzes (31) der mikroelektronischen Vorrichtung (30) an dem Verbindungskabel (32) in zusammengesetzter Position zu ermöglichen.

7. Gehäuse nach dem vorstehenden Anspruch, wobei das Kompressionskabel (32) komprimierbar ist.

8. Gehäuse nach einem der beiden vorstehenden Ansprüche, wobei die Höhe des Grabens (24, 17) kleiner als der Durchmesser des Verbindungskabels (32) ist.

9. Gehäuse nach einem der vorstehenden Ansprüche, wobei der erste Teil (10) und der zweite Teil (20) jeweils mindestens ein Anschlusselement beinhalten.

10. Gehäuse nach einem der vorstehenden Ansprüche, wobei der Hohlraum (12) ein elastisch verformbares, komprimierbares Organ (35) umfasst, und konfiguriert ist, um durch die mikroelektronische Vorrichtung (30) in zusammengesetzter Position komprimiert zu werden.

11. Gehäuse nach einem der vorstehenden Ansprüche, wobei mindestens einer aus dem ersten Teil (10) und dem zweiten Teil (20) ein Fenster beinhaltet, das von der Außenwand des Teils in den Hohlraum (12) mündet.

12. Gehäuse nach einem der vorstehenden Ansprüche, umfassend Mittel zur mechanischen Befestigung und/ oder durch Kleben des ersten Teils (10) auf dem zweiten Teil (20) in zusammengesetzter Position.

13. Gehäuse nach einem der vorstehenden Ansprüche, wobei der erste Teil (10) und der zweite Teil (20) durch eine Scharnierverbindung (28) im Bereich eines Randes ihrer Seiten gekoppelt sind.

14. System, mindestens eine mikroelektronische Vorrichtung (30) umfassend, die im Inneren des Hohlraumes (12) eines Gehäuses nach einem der vorstehenden Ansprüche untergebracht ist.

15. System nach dem vorstehenden Anspruch, umfassend mehrere mikroelektronische Vorrichtungen, die im Inneren des Hohlraumes (12) untergebracht sind, wobei mindestens ein Teil der mikroelektronischen Vorrichtungen elektrisch durch mindestens ein Anschlusselement gekoppelt sind.

16. Verfahren zur Montage einer mikroelektronischen Vorrichtung in einem Gehäuse, wobei das Gehäuse einen ersten Teil (10) und einen zweiten Teil (20) umfasst, die zusammensetzbar sind, um in einer zusammengesetzten Position einen Raum zur Aufnahme der mikroelektronischen Vorrichtung (30) zu definieren, wobei mindestens einer aus dem ersten Teil und zweiten Teil mindestens ein elektrisches Anschlusselement umfasst, wobei das Verfahren umfasst:
- ein Einsetzen der mikroelektronischen Vorrichtung (30) in den Raum zum Unterbringen, wobei der erste Teil (10) und der zweite Teil (20) nicht in zusammengesetzter Position sind;
- einander Gegenübersetzen einer Seite des ersten Teils (10) und einer Seite des zweiten Teils (20), derart, um die Teile in zusammengesetzter Position zu platzieren, wobei erste Zonen gegenüber den Seiten eine Schnittstelle zur festen Verbindung des ersten Teils und zweiten Teils bilden, zweite Zonen gegenüber den Seiten einen Hohlraum (12) zur Aufnahme der mikroelektronischen Vorrichtung (30) bilden, das Anschlusselement in den Hohlraum (12) mündet, und einen Graben (24) beinhaltend, der ein Verbindungskabel (32) aufnimmt,
- ein Anlegen mindestens eines Verbindungsklotzes (31) der mikroelektronischen Vorrichtung (30) an dem Anschlusselement in zusammengesetzter Position des ersten Teils (10) und des zweiten Teils (20) durch einen Druck, der durch das erste Teil (10) und das zweite Teil (20) erzeugt wird.

17. Verwendung mindestens eines Gehäuses nach einem der Ansprüche 1 bis 13 zum Unterbringen einer mikroelektronischen Vorrichtung in dem Hohlraum des Gehäuses.

## Claims

1. A package for a microelectronic device, comprising a first part (10) and a second part (20) which can be assembled to define, in an assembled position, a space for housing the microelectronic device (30), wherein a face of the first part (10) is opposite a face of the second part (20) in the assembled position, first areas opposite the faces forming an interface for securing said first part (10) and second part (20), second areas opposite the faces forming a cavity (12) for receiving the microelectronic device (30), at least one of the first part (10) and the second part (20) comprising at least one electrical connecting element comprising a connection cable (32), opening into the cavity (12) and including a trench (24) receiving the connection cable (32), the first part (10) and the second part (20) being configured to apply at least one connection pad (31) of the microelectronic device (30) on the connecting element, by a pressure produced by the first part (10) and the second part (20), in the assembled position.

2. The package according to the preceding claim, wherein the first part (10) is configured to exert a pressure on the microelectronic device (30) towards the face of the second part (20).

3. The package according to the preceding claim, wherein the cavity (12) is delimited by a recessed pattern in the first part (10), the recessed pattern having a bottom (14) configured to exert a pressure on the microelectronic device (30).

4. The package according to one of the preceding claims, wherein at least one connecting element includes an interconnection member (34) opening into the cavity (12) so as to make a connection pad (31) of the microelectronic device (30) applicable on the interconnection member (34) in the assembled position, the interconnection member (34) being electrically linked to the connection cable (32).

5. The package according to the preceding claim, wherein that of the first part (10) and the second part (20) which does not comprise said connecting element comprises a lug (16) opposite the trench (24) of the connecting element, configured to exert a pressure on the connection cable (32) in the assembled position.

6. The package according to one of the preceding claims, wherein the trench (24, 17) of at least one connecting element opens into the cavity (12) and receives the connection cable (32) so as to allow the application of a connection pad (31) of the microelectronic device (30) on the connection cable (32) in the assembled position.

7. The package according to the preceding claim, wherein the compression cable (32) is compressible.

8. The package according to one of the two preceding claims, wherein the height of the trench (24, 17) is less than the diameter of the connection cable (32).

9. The package according to one of the preceding claims, wherein the first part (10) and the second part (20) each include at least one connecting element.

10. The package according to one of the preceding claims, wherein the cavity (12) comprises a compressible member (35) elastically deformable and configured to be compressed by the microelectronic device (30) in the assembled position.

11. The package according to one of the preceding claims, wherein at least one of the first part (10) and the second part (20) includes a window opening into the cavity (12) from the outer wall of said part.

12. The package according to one of the preceding claims, comprising means for mechanically fixing and/or fixing by gluing the first part (10) on the second part (20) in the assembled position.

13. The package according to one of the preceding claims, wherein the first part (10) and the second part (20) are linked by a hinge linkage (28) at one edge of their faces.

14. A system comprising at least one microelectronic device (30) housed inside the cavity 12 of a package according to one of the preceding claims.

15. The system according to the preceding claim, comprising several microelectronic devices housed inside the cavity 12, at least part of said microelectronic devices being electrically linked by at least one connecting element.

16. A method for mounting a microelectronic device in a package, the package comprising a first part (10) and a second part (20) that can be assembled to define, in an assembled position, a space for housing the microelectronic device (30), at least one of the first part and the second part comprising at least one electrical connecting element, the method comprising:
- placing the microelectronic device (30) in the housing space, the first part (10) and the second part (20) not being in the assembled position;
- placing a face of the first part (10) opposite a face of the second part (20) so as to place said parts in the assembled position, first areas opposite the faces forming an interface for securing said first part and second part, second areas opposite the faces forming a cavity (12) for receiving the microelectronic device (30), the connecting element opening into the cavity (12) and including a trench (24) receiving a connection cable (32),
- applying at least one connection pad (31) of the microelectronic device (30) on the connecting element in the assembled position of the first part (10) and of the second part (20), by a pressure produced by the first part (10) and the second part (20).

17. A use of at least one package according to one of claims 1 to 13 for housing a microelectronic device in the cavity of the package.
